# EUROPÄISCHE PATENTSCHRIFT

(11) **EP 2 735 034 B1**
(45) Veröffentlichungstag und Bekanntmachung des Hinweises auf die Patenterteilung: **21.02.2018**
(21) Anmeldenummer: 12740560.3
(22) Anmeldetag: 20.07.2012
(51) Int. Cl.: H01L 35/10, B22F 7/08, C22C 1/00, C22C 45/10

(54) **THERMOELEKTRISCHES MODUL UND VERFAHREN ZUR HERSTELLUNG EINES THERMOELEKTRISCHEN MODULS**
THERMOELECTRIC MODULE AND METHOD FOR PRODUCING A THERMOELECTRIC MODULE
MODULE THERMOÉLECTRIQUE ET PROCÉDÉ DE FABRICATION D'UN MODULE THERMOÉLECTRIQUE

(30) Priorität: 20.07.2011 DE 102011079467
(43) Veröffentlichungstag der Anmeldung: 28.05.2014
(73) Patentinhaber: MAHLE Behr GmbH & Co. KG, 70469 Stuttgart (DE)
(72) Erfinder: ANGERMANN, Hans-Heinrich, 70567 Stuttgart (DE)
(74) Vertreter: Grauel, Andreas
(86) Internationale Anmeldenummer: PCT/EP2012/064288
(87) Internationale Veröffentlichungsnummer: WO 2013/011127

(56) Entgegenhaltungen:
- EP-A1- 1 835 551
- DE-A1- 1 558 644
- JP-A- 2003 017 759
- JP-A- 2003 282 796
- US-A- 3 859 143
- US-A1- 2002 024 154
- US-A1- 2002 179 135
- US-A1- 2007 034 305
- US-A1- 2009 032 970
- PEKER A ET AL: "A HIGHLY PROCESSABLE METALLIC GLASS: ZR41.2TI13.8CU12.5NI10.0BE22.5", APPLIED PHYSICS LETTERS, AIP, AMERICAN INSTITUTE OF PHYSICS, MELVILLE, NY, US, Bd. 63, Nr. 17, 25. Oktober 1993 (1993-10-25), Seiten 2342-2344, XP000408801, ISSN: 0003-6951, DOI: 10.1063/1.110520

## Beschreibung

Die vorliegende Erfindung bezieht sich auf ein thermoelektrisches Modul, auf ein Verfahren zur Herstellung eines thermoelektrischen Moduls und auf eine Verwendung eines metallischen Glases als Material für eine Leiterbahn eines thermoelektrischen Moduls.
Thermoelektrische Module werden unter Verwendung von Fügematerialien hergestellt. Bezüglich Fügematerialien sind Weichlötverbindungen einfach zu realisieren und werden auch oft verwendet. Die Fügepartner müssen gegebenenfalls lediglich metallisiert werden. Diese Fügenähte sind jedoch durch die Wiederaufschmelztemperatur der Weichlotverbindung in Ihrer maximalen Temperatur eingeschränkt. Aber auch unterhalb der Solidustemperatur des Lotes können in der Sn-Basis Fügenaht Risse durch thermisches Zyklieren entstehen.

In der (nicht-vorveröffenlichten) deutschen Patentanmeldung 10 2011 005 246.1 wird vorgeschlagen, erstens ein thermoelektrisches Modul aus Werkstoffen mit ähnlichen thermischen Ausdehnungskoeffizienten aufzubauen und zweitens das Modul entweder Schritt für Schritt durch thermisches Spritzen zu erzeugen oder bestehende thermoelektrische Bausteine mittels Löten oder Ag-Drucksintern aufzufügen. Der theoretisch richtige Weg des Aufbaus komplett über thermisches Spritzen ist in der Praxis schwierig zu realisieren, da der Aufbau der thermoelektrischen Materialien über das thermische Spritzen unter Luftabschluss erfolgen muss und die an sich schon nicht so gut verfügbaren und oxidationsanfälligen thermoelektrischen Werkstoffe in Pulverform verspritzt werden müssen.

In der nicht-vorveröffentlichen deutschen Patentanmeldung 10 2011 075 902.6 wird ein Modul offenbart, das aus Grundelementen und mittels thermischer Presstechniken aufgebrachten TE-Bausteinen aufgebaut ist. Es wird wieder darauf geachtet, dass Werkstoffe mit gleichem oder ähnlichem thermischen Ausdehnungskoeffizienten verwendet werden. Es ist jedoch nicht immer möglich, solche Materialien zu verwenden, da auch andere Randbedingungen von den Werkstoffen erfüllt werden müssen. Es wäre wünschenswert größere Freiheit bei der Materialauswahl zu haben.

US2002/0179135 A1 offenbart ein thermoelektrisches Modul, mit folgenden Merkmalen: einer elektrischen Isolierung; einer elektrischen Leiterbahn, wobei eine Oberfläche der elektrischen Leiterbahn an eine Oberfläche der elektrischen Isolierung angefügt ist; und einem thermoelektrischen Material, wobei eine Oberfläche des thermoelektrischen Materials an eine weitere Oberfläche der elektrischen Leiterbahn angefügt ist, mit einer weiteren elektrischen Leiterbahn, die auf einer der elektrischen Leiterbahn gegenüberliegenden Seite des thermoelektrischen Materials angeordnet ist und mit einer weiteren elektrischen Isolierung, die auf einer dem thermoelektrischen Material gegenüberliegenden Seite der weiteren elektrischen Leiterbahn angeordnet ist, wobei die elektrische Leiterbahn aus einem gesinterten Werkstoff besteht, wobei der thermische Ausdehnungskoeffizient der elektrischen Isolierung kleiner als der thermische Ausdehnungskoeffizient der elektrischen Leiterbahn und der thermische Ausdehnungskoeffizient der elektrischen Leiterbahn kleiner als der thermische Ausdehnungskoeffizient des thermoelektrischen Materials ist. US2007/0034305 A1 offenbart die Verwendung eines metallischen Glases als Lot.

Es ist die Aufgabe der vorliegenden Erfindung ein verbessertes thermoelektrisches Modul, ein verbessertes Verfahren zur Herstellung eines thermoelektrischen Moduls und eine neue Verwendung eines metallischen Glases zu schaffen.

Diese Aufgabe wird durch ein thermoelektrisches Modul, ein Verfahren zur Herstellung eines thermoelektrischen Moduls und durch eine Verwendung eines metallischen Glases gemäß den Hauptansprüchen gelöst.

Thermoelektrische Module werden sowohl als Peltier-Elemente, als auch als thermoelektrische Generatoren benutzt. Der grundlegende Aufbau für beide Anwendungen ist derselbe. Zunächst sorgt außen eine elektrisch nicht-leitende Schicht, z. B. aus Keramik, für eine elektrische Isolierung. Im Inneren der Module befinden sich thermoelektrisch aktive Materialien, die an elektrische Leiterbahnen gefügt miteinander gut elektrisch leitend verbunden sind.

Erwünscht ist sowohl bei der Anwendung als Peltier-Element als auch als thermoelektrischer Generator ein möglichst großer Temperaturunterschied zwischen der heißen und der kalten Seite. Beim Peltier-Element soll für das Heizen und Kühlen eine möglichst hohe Temperatur auf der heißen bzw. eine möglichst niedrige Temperatur auf der kalten Seite realisiert werden. Beim thermoelektrischen Generator wird durch eine möglichst große Temperaturdifferenz zwischen der Heiß- und Kaltseite die Spannungs- und Stromerzeugung maximiert. Da die Temperaturen beim Hochfahren der Module schnell anliegen, entstehen durch Temperaturunterschiede und durch die Verwendung von Materialien mit unterschiedlichen thermischen Ausdehnungskoeffizienten dementsprechend große thermomechanische Spannung von der einen keramischen Decklage über die Leiterbahnen, Fügewerkstoffe und thermoelektrischen Materialien hin zur anderen keramischen Decklage. Je höher die Temperaturen sind, bei denen die Bauteile betrieben werden, desto höher sind auch die thermomechanischen Belastungen und somit die Gefahr, dass die Bauteile im Betrieb vorzeitig versagen.

Gemäß dem beschriebenen Ansatz wird zum Fügen von Leiterbahnen eines thermoelektrischen Moduls an deren Peripherie kein separates Fügematerial verwendet. Stattdessen fungieren die Leiterbahnen sowohl als Stromleiter als auch als Fügematerial bei der Modulherstellung. Als Material für die Leiterbahnen werden massiv metallische Gläser oder alternativ dazu gesinterte Werkstoffe bevorzugt auf Ag-Basis vorgeschlagen. Das Fügen der Leiterbahnen auf eine keramische Deckschicht des thermoelektrischen Moduls und das Fügen der thermoelektrischen Werkstoffe des thermoelektrischen Moduls auf die Leiterbahnen kann bevorzugt in einem Schritt erfolgen. Es sind jedoch auch getrennte Fügeschritte möglich. Zum Fügen aller oder zumindest einer Leiterbahn des thermoelektrischen Moduls kann auf ein separates Fügematerial, verzichtet werden. Die vorgeschlagene Technik kann auf beiden oder nur auf einer Seite des thermoelektrischen Moduls verwendet werden. Die dabei zugrundeliegende Lehre bezüglich Werkstoffen und Verfahren für eine elektrisch gut leitende und thermomechanisch gut haltbare Fügung innerhalb von thermoelektrischen Modulen ermöglicht eine Anwendung der thermoelektrischen Module bei höheren Temperaturen von mehr als 200 °C.

Vorteilhafterweise ergibt sich dadurch eine größere Freiheit bei der Materialauswahl für Grundmaterial, elektrische Isolierung und TE-Material durch Aufnahme der Spannungen in der Fügenaht-Leiterbahn, ein einfaches Fügen mit bekannten Methoden und eine Möglichkeit zum Bau eines thermoelektrischen Moduls für erhöhte oder hohe Temperaturen.

Die vorliegende Erfindung schafft ein thermoelektrisches Modul, mit folgenden Merkmalen:
einer elektrischen Isolierung;
einer elektrischen Leiterbahn, wobei eine Oberfläche der elektrischen Leiterbahn an eine Oberfläche der elektrischen Isolierung angefügt ist; und
einem thermoelektrischen Material, wobei eine Oberfläche des thermoelektrischen Materials an eine weitere Oberfläche der elektrischen Leiterbahn angefügt ist,
mit einer weiteren elektrischen Leiterbahn, die auf einer der elektrischen Leiterbahn gegenüberliegenden Seite des thermoelektrischen Materials angeordnet ist und mit einer weiteren elektrischen Isolierung, die auf einer dem thermoelektrischen Material gegenüberliegenden Seite der weiteren elektrischen Leiterbahn angeordnet ist, wobei die elektrische Leiterbahn aus einem metallischen Glas besteht,
wobei der thermische Ausdehnungskoeffizient der elektrischen Isolierung kleiner als der thermische Ausdehnungskoeffizient der elektrischen Leiterbahn und der thermische Ausdehnungskoeffizient der elektrischen Leiterbahn kleiner als der thermische Ausdehnungskoeffizient des thermoelektrischen Materials ist. Ein thermoelektrisches Modul kann als ein elektrothermischer Wandler aufgefasst werden. Das thermoelektrische Modul kann sowohl als Peltier-Element, bei dem ein Stromfluss eine Temperaturdifferenz bewirkt, als auch als thermoelektrischer Generator, bei dem eine Temperaturdifferenz einen Stromfluss bewirkt, eingesetzt werden. Diese Effekte des thermoelektrischen Moduls können durch eine elektrisch leitfähige Verbindung zweier Halbleitern mit unterschiedlichen Energieniveaus, beispielsweise einem p-leitenden Halbleiter und einem n-leitenden Halbleiter, hervorgerufen werden. Die elektrische Isolierung, die elektrische Leiterbahn und das thermoelektrische Material können in einem Schichtaufbau oder übereinandergestapelt angeordnet sein. Die elektrische Isolierung kann sich als Schicht oder auf einem Blech über eine gesamte Grundfläche des thermoelektrischen Moduls erstrecken. Die elektrische Isolierung kann auf einer Schicht aus einem metallischen Grundwerkstoff angeordnet sein. Die elektrische Leiterbahn kann eine einer Mehrzahl von auf der elektrischen Isolierung angeordneten elektrischen Leiterbahnen sein. Die elektrische Leiterbahn ist ausgebildet, um eine elektrisch leitfähige Verbindung zwischen mehreren thermoelektrischen Materialien, beispielsweise zwischen zwei unterschiedlichen thermoelektrischen Materialien des thermoelektrischen Moduls zu schaffen. Bei dem thermoelektrischen Material kann es sich um einen Halbleiter handeln. Durch das thermoelektrische Material kann eines einer Mehrzahl von thermoelektrischen Elementen des thermoelektrischen Moduls realisiert sein. Bei dem thermoelektrischen Material kann es sich um ein p-dotiertes oder um ein n-dotiertes Halbleitermaterial handeln. Jeweils zwei aus unterschiedlichem thermoelektrischem Material bestehende thermoelektrische Elemente können über eine elektrische Leiterbahn elektrisch leitfähig miteinander verbunden sein. Die Oberfläche der elektrischen Isolierung kann aus einem Hauptmaterial der elektrischen Isolierung bestehen. Auch kann die Oberfläche durch eine auf dem Hauptmaterial der elektrischen Isolierung angeordneten Metallisierung oder Haftvermittlung gebildet sein, beispielweise aus einer Nickellegierung. Eine die Oberfläche der elektrischen Isolierung ausbildende Haftvermittlungsschicht oder Metallisierungsschicht kann eine für Metallisierungen übliche Dicke, beispielsweise von 5 bis 15 µm aufweisen. Ein Material der Oberfläche der elektrischen Isolierung kann als Weichlot ungeeignet sein. Ein Material der Oberfläche der elektrischen Isolierung kann eine Schmelztemperatur aufweisen, die oberhalb von 200 °C liegt. Die Oberfläche des thermoelektrischen Materials kann aus dem thermoelektrischen Material bestehen. Auch kann die Oberfläche des thermoelektrischen Materials durch eine auf dem thermoelektrischen Material angeordnete Diffusionsbarriere oder Haftvermittlungsschicht bestehen. Ein Material der Oberfläche des thermoelektrischen Materials kann wiederum als Weichlot ungeeignet sein. Die jeweiligen Oberflächen des thermoelektrischen Materials können durch ein Fügeverfahren zusammengefügt sein. Hier kann Fügen als ein Verpressvorgang verstanden werden. Das die Fügenähte zwischen den Oberflächen herstellende Fügeverfahren kann somit hauptsächlich auf der Anwendung von Druck basieren. Es kann sich also um Fügen durch Anpressen handeln. Dadurch kann die Fügeverbindung zwischen den einzelnen Oberflächen so realisiert sein, dass sich die Oberflächen direkt berühren und zwischen den Materialien der gefügten Oberflächen eine mechanische und keine chemische Bindung besteht. Zwischen den Oberflächen befindet sich somit kein zusätzliches Fügematerial, wie beispielsweise Weichlot.

Die elektrische Leiterbahn besteht aus einem metallischen Glas Bei dem metallischen Glas kann es sich um ein massiv metallisches Glas handeln. Bei dem metallischen Glas kann es sich um eine Legierung handeln, die auf atomarer Ebene eine amorphe Struktur aufweist. Metallisches Glas eignet sich als elektrische Leiterbahn, da es elektrisch leitfähig ist, eine hohe Schmelz- bzw. Erweichungstemperatur aufweist und zur Aufnahme von thermomechanischen Spannungen geeignet ist.

Die thermischen Ausdehnungskoeffizienten der elektrischen Isolierung, der elektrischen Leiterbahn und des thermoelektrischen Materials können aufeinander abgestimmt sein. Die in der DE 10 2011 005 246.1 vorgeschlagene Lehre kann dazu voll übernommen werden. Beispielsweise können die Ausdehnungskoeffizienten innerhalb eines Toleranzbereichs von 10% des höchsten thermischen Ausdehnungskoeffizienten liegen.
Beispielsweise können die thermischen Ausdehnungskoeffizienten entlang eines Querschnitts durch das thermoelektrische Modul abgestuft sein. So kann der thermische Ausdehnungskoeffizient der elektrischen Isolierung kleiner als der thermische Ausdehnungskoeffizient der elektrischen Leiterbahn und der thermische Ausdehnungskoeffizient der elektrischen Leiterbahn kleiner als der thermische Ausdehnungskoeffizient des thermoelektrischen Materials sein.

Das thermoelektrische Modul hat eine weitere elektrische Leiterbahn, die auf einer der elektrischen Leiterbahn gegenüber liegenden Seite des thermoelektrischen Materials angeordnet ist. Ferner hat das thermoelektrische Modul eine weitere elektrische Isolierung, die auf einer dem thermoelektrischen Material gegenüberliegenden Seite der weiteren elektrischen Leiterbahn angeordnet ist. Die weitere elektrische Leiterbahn kann mit dem thermoelektrischen Material und der weiteren elektrischen Isolierung verlötet sein. Alternativ können aneinander angrenzende Oberflächen der weiteren elektrischen Leiterbahn und der weiteren elektrischen Isolierung sowie der weiteren elektrischen Leiterbahn und des thermoelektrischen Materials, wie beschrieben, miteinander verfügt sein, also ohne Eingehen einer chemischen Verbindung fest miteinander verbunden sein. Dabei können die elektrische Leiterbahn und die weitere elektrische Leiterbahn jeweils aus metallischem Glas, jeweils aus gesintertem Werkstoff bestehen. Auch kann die elektrische Leiterbahn aus metallischem Glas und die weitere elektrische Leiterbahn aus gesintertem Werkstoff bestehen, oder umgekehrt. Der thermischen Ausdehnungskoeffizienten der für die einzelnen Schichten verwendeten Materialien können wie bereits beschrieben aufeinander abgestimmt, insbesondere auch abgestuft sein.
Die vorliegende Erfindung schafft ferner ein Verfahren zur Herstellung eines thermoelektrischen Moduls, das die folgenden Schritte umfasst:
Bereitstellen einer elektrischen Isolierung;
Anfügen einer Oberfläche einer elektrischen Leiterbahn an eine Oberfläche der elektrischen Isolierung; und
Anfügen einer Oberfläche eines thermoelektrischen Materials an eine weitere Oberfläche der elektrischen Leiterbahn,
wobei die Schritte des Anfügens als ein Verpressvorgang zeitgleich durchgeführt werden,
mit einem Schritt des Legens der aus metallischem Glas bestehenden elektrischen Leiterbahn auf die elektrische Isolierung oder mit einem Schritt des Spritzens eines die aus metallischem Glas bestehende elektrischen Leiterbahn ausbildenden Leiterbahnmaterials auf die elektrische Isolierung. Die Schritte des Anfügens können als Verpressen durchgeführt werden. Auf diese Weise können die Oberflächen mechanisch miteinander verbunden werden, indem sich die Oberflächenstrukturen der direkt aneinandergrenzenden und sich berührenden Oberflächen miteinander verhaken. Dabei kann auf bekannte Fügeverfahren zurückgegriffen werden. Vor dem Schritt des Anfügens der elektrischen Leiterbahn kann ein Schritt des Anordnens der elektrischen Leiterbahn auf der elektrischen Isolierung durchgeführt werden. Bei einem eine Mehrzahl elektrischer Leiterbahnen umfassenden thermoelektrischen Modul kann die Mehrzahl elektrischer Leiterbahnen in dem Schritt des Anordnens gleichzeitig auf der elektrischen Isolierung angeordnet werden und im Schritt des Anfügens gleichzeitig an die elektrische Isolierung angefügt werden. Vor dem Schritt des Anfügens des thermoelektrischen Materials kann ein Schritt des Anordnens des thermoelektrischen Materials auf der elektrischen Leiterbahn durchgeführt werden. Bei einem eine Mehrzahl aus thermoelektrischen Material gebildeten thermoelektrischen Elementen umfassenden thermoelektrischen Modul kann das die Mehrzahl thermoelektrische Elemente bildende thermoelektrischen Material in dem Schritt des Anordnens gleichzeitig oder bei zwei unterschiedlichen thermoelektrischen Materialien auch in zwei Schritten auf der elektrischen Isolierung angeordnet werden und im Schritt des Anfügens gleichzeitig an die elektrische Isolierung angefügt werden. Die elektrische Isolierung kann über thermisches Spritzen auf einen Grundwerkstoff aufgebracht werden, wie es in der deutschen Patentanmeldung 10 2011 005 246.1 vorgeschlagen wird. Die Schritte des Anfügens können gleichzeitig oder zeitlich getrennt durchgeführt werden. Erfindungsgemäß werden die Schritte des Anfügens als ein Verpressvorgang zeitgleich durchgeführt. Dadurch kann das Herstellungsverfahren vereinfacht und beschleunigt werden.

Das Verfahren umfasst einen Schritt des Legens der aus metallischem Glas bestehenden elektrischen Leiterbahn auf die elektrische Isolierung. Dies bietet sich an, wenn die elektrische Leiterbahn bereits vorgefertigt ist.

Alternativ umfasst das Verfahren einen Schritt des Spritzens eines die aus metallischem Glas bestehende elektrischen Leiterbahn ausbildenden Leiterbahnmaterials auf die elektrische Isolierung. In diesem Fall kann die elektrische Leiterbahn direkt auf der elektrischen Isolierung ausgeformt werden.

Auch kann das Verfahren einen Schritt des Sinterns der aus einem gesinterten Werkstoff bestehenden elektrischen Leiterbahn auf die elektrische Isolierung umfassen. Dazu kann ein Grundstoff der elektrischen Leiterbahn zunächst auf die elektrische Isolierung aufgebracht werden gefügt werden. Aus der DE 10 2007 046 901 A1 und der WO 2011/026624 A1 sind Metallpasten bekannt, die eine Silberverbindung enthalten und die bei Temperaturen unter 300 bzw. unter 200 °C zu einer stabilen porösen Ag-Schicht sintern. In diesem Fall können die Schritte des Anfügens drucklos oder unter Anwendung von Druck durchgeführt werden.

Das Verfahren kann einen Schritt des Anfügens einer Oberfläche einer weiteren elektrischen Leiterbahn an eine der elektrischen Leiterbahn gegenüberliegenden Oberfläche des thermoelektrischen Materials und einen Schritt des Anfügens einer Oberfläche einer weiteren elektrischen Isolierung an eine dem thermoelektrischen Material gegenüberliegenden Oberfläche der weiteren elektrischen Leiterbahn umfassen. Auf diese Weise kann ein thermoelektrisches Modul hergestellt werden, dessen Leiterbahnen auf gegenüberliegenden Seiten des thermoelektrischen Materials jeweils mit den jeweils angrenzenden Materialien jeweils über eine Fügenaht verbunden sind.

Vorteilhafte Ausführungsbeispiele der vorliegenden Erfindung werden nachfolgend Bezug nehmend auf die beiliegenden Zeichnungen näher erläutert. Es zeigen:
- Fig. 1: eine Darstellung eines thermoelektrischen Moduls;
- Fig. 2: eine Ausschnittdarstellung eines thermoelektrischen Moduls;
- Fig. 3: eine Darstellung eines erfindungsgemäßen thermoelektrischen Moduls;
- Fig. 4: eine Ausschnittdarstellung eines erfindungsgemäßen thermoelektrischen Moduls; und
- Fig. 5: ein Ablaufdiagramm zur Herstellung eines thermoelektrischen Moduls.

In der nachfolgenden Beschreibung der bevorzugten Ausführungsbeispiele der vorliegenden Erfindung werden für die in den verschiedenen Zeichnungen dargestellten und ähnlich wirkenden Elemente gleiche oder ähnliche Bezugszeichen verwendet, wobei eine wiederholte Beschreibung dieser Elemente weggelassen wird.
Thermoelektrische Module werden sowohl als Peltier-Elemente, als auch als thermoelektrische Generatoren benutzt. Der grundlegende Aufbau für beide Anwendungen ist derselbe. Zunächst sorgt außen eine elektrisch nicht-leitende Schicht, z. B. aus Keramik, für eine elektrische Isolierung. Im Inneren der Module befinden sich thermoelektrisch aktive Materialien, die an elektrische Leiterbahnen gefügt miteinander gut elektrisch leitend verbunden sind.

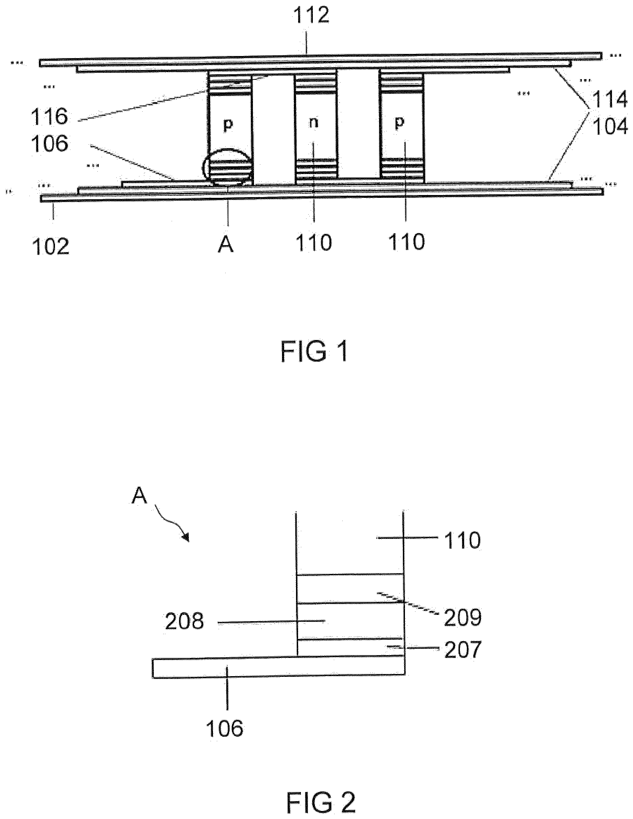

Fig. 1 zeigt eine Darstellung eines thermoelektrischen Moduls. Das thermoelektrische Modul weist einen Schichtaufbau aus einem metallischen Grundwerkstoff 102, einer elektrischen Isolierung 104, Leiterbahnen 106, Fügematerial, thermoelektrischem p- und n-Material 110, weiterem Fügematerial, weiteren Leiterbahnen 116, einer weiteren elektrischen Isolierung 114 und einem weiteren metallischen Grundwerkstoff 112 auf. Im Betrieb des thermoelektrischen Moduls kann der metallischen Grundwerkstoff 102 auf einer kalten Seite des thermoelektrischen Moduls und der weitere metallische Grundwerkstoff 112 auf einer heißen Seite des thermoelektrischen Moduls angeordnet sein.

Als Fügematerial zwischen den Leiterbahnen 106, 116 und dem thermoelektrischem Werkstoff 110 kann ein Lot verwendet werden. Fig. 1 zeigt eine Prinzipskizze eines solchen Aufbaus. Die elektrische Isolierung 104, 114 ist jeweils als eine keramische Seite ausgeführt. Das Modul ist mit der keramischen Seite auf der kalten und/oder heißen Seite an metallische Wärmeübertrager 102, 112 aus einem metallischen Grundwerkstoff angebunden.

Fig. 2 eine Ausschnittdarstellung A eines unteren Sockels des in Fig. 1 links dargestellten thermoelektrischen Materials 110. Gezeigt ist ein Abschnitt der Leiterbahn 106, auf der eine als Diffusionsbarriere, Haftvermittlungsschicht oder ähnliches fungierende Schicht 207 angeordnet ist. Auf der Schicht 207 ist das Fügematerial 208 angeordnet, auf dem wiederum eine als Diffusionsbarriere, Haftvermittlungsschicht oder ähnliches fungierende Schicht 209 angeordnet ist. Auf der Schicht 209 ist das thermoelektrische Material 110 angeordnet.

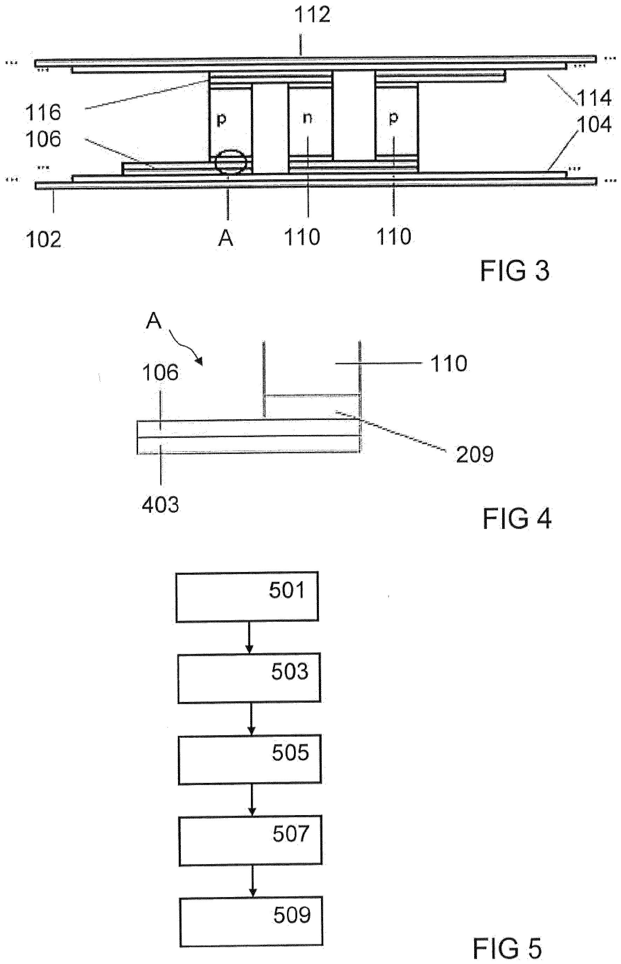

Fig. 3 zeigt eine Darstellung eines erfindungsgemäßen thermoelektrischen Moduls gemäß einem Ausführungsbeispiel der vorliegenden Erfindung. Das thermoelektrische Modul weist einen Schichtaufbau aus einem metallischen Grundwerkstoff 102, einer elektrischen Isolierung 104, Leiterbahnen 106, thermoelektrischem p- und n-Material 110, weiteren Leiterbahnen 116, einer weiteren elektrischen Isolierung 114 und einem weiteren metallischen Grundwerkstoff 112 auf. Im Betrieb des thermoelektrischen Moduls kann der metallischen Grundwerkstoff 102 auf einer kalten Seite des thermoelektrischen Moduls und der weitere metallische Grundwerkstoff 112 auf einer heißen Seite des thermoelektrischen Moduls angeordnet sein.

Die metallischen Grundwerkstoffe 102, 112 sind als zwei parallel und gegenüberliegend angeordnete Schichten ausgebildet. Die metallischen Grundwerkstoffe 102, 112 bilden zwei gegenüberliegende Grundflächen des thermoelektrischen Moduls. Die metallischen Grundwerkstoffe 102, 112 können als Wärmeübertragungsflächen des thermoelektrischen Moduls dienen und als Anbindung an einen hier nicht näher definierten Wärmeübertrager.

Die elektrischen Isolierungen 104, 114 sind als zwei parallel und gegenüberliegend angeordnete Schichten ausgebildet. Eine Oberfläche der elektrischen Isolierung 104 ist mit einer Oberfläche des metallischen Grundwerkstoffs 102 verbunden. Eine Oberfläche der elektrischen Isolierung 114 ist direkt angrenzend mit einer Oberfläche des metallischen Grundwerkstoffs 112 verbunden, so dass sich die Oberflächen der elektrischen Isolierung 114 und des metallischen Grundwerkstoffs 112 berühren. Die elektrischen Isolierungen 104, 114 können sich jeweils über eine gesamte Fläche des metallischen Grundwerkstoffs 112 oder zumindest über Bereiche der Leiterbahnen 106, 116 erstrecken. Die elektrischen Isolierungen 104, 114 sind ausgebildet, um die Leiterbahnen 106, 116 von den metallischen Grundwerkstoffen 102, 112 elektrisch zu isolieren.

Die elektrischen Leiterbahnen 106, 116 sind in zwei parallel und gegenüberliegend angeordnete Ebenen angeordnet. In jeder der Ebenen sind eine Mehrzahl von Leiterbahnen 106, 116 angeordnet. Gemäß diesem Ausführungsbeispiel verbindet eine der Leiterbahnen 106, 116 jeweils zwei aus unterschiedlichem thermoelektrischen Material bestehende thermoelektrische Elemente elektrisch leitfähig. Benachbarte Leiterbahnen 106, 116 innerhalb einer Ebene sind voneinander beabstandet angeordnet.

Die säulenförmig dargestellten thermoelektrischen Materialien 110 bilden jeweils ein thermoelektrisches Element. In Fig. 3 sind beispielhaft drei thermoelektrische Elemente gezeigt, wobei das links gezeigte thermoelektrische Element aus einem p-dotierten Halbleitermaterial, das in der Mitte gezeigte thermoelektrische Element aus einem n-dotierten Halbleitermaterial und das rechts gezeigte thermoelektrische Element aus einem p-dotierten Halbleitermaterial besteht. Das thermoelektrische Modul kann eine Mehrzahl weiterer thermoelektrische Elemente aufweisen, die benachbart zu den gezeigten thermoelektrische Elementen zwischen weiteren der Leiterbahnen 106, 116 angeordnet sind. Die einzelnen thermoelektrischen Materialien 110 sind voneinander beabstandet angeordnet. Benachbarte thermoelektrische Materialien 110 sind nur über verbindende Leiterbahnen 106, 116 elektrische leitfähig miteinander verbunden.

Ein elektrischer Stromfluss durch das thermoelektrische Modul ist durch die linke der gezeigten Leiterbahnen 106, das linke der gezeigten thermoelektrischen Materialien 110, die linke der gezeigten Leiterbahnen 116, das mittlere der gezeigte thermoelektrischen Materialen 110, die rechte der gezeigten Leiterbahnen 106, das rechte der gezeigten thermoelektrischen Materialien 110 und die rechte der gezeigten Leiterbahnen 116, oder umgekehrt, möglich. Auf diese Weise sind die thermoelektrischen Materialien 110 in einer Reihenschaltung angeordnet, wobei in der Reihenschaltung abwechselnd thermoelektrische Element aus einem p-dotierten Halbleitermaterial und thermoelektrische Element aus einem n-dotierten Halbleitermaterial angeordnet sind. Über eine geeignete Anordnung der Leiterbahnen 106, 116 können auch zwei oder mehr thermoelektrischen Materialien 110 parallel verschaltet sein.

Fig. 4 zeigt eine Ausschnittdarstellung A eines unteren Sockels des in Fig. 3 links dargestellten thermoelektrischen Materials 110. Gezeigt ist ein Abschnitt der Leiterbahn 106, auf der eine als Diffusionsbarriere, Haftvermittlungsschicht oder ähnliches fungierende Schicht 209 angeordnet ist. Die Schicht 209 kann aus Ag, Ni, Cu, Al, Au, deren Legierungen oder dergleichen Materialien bestehen. Auf der Schicht 209 ist das thermoelektrische Material 110 angeordnet. Unter der Leiterbahn 106 ist eine als Metallisierung, Haftvermittlung oder ähnliches fungierende Schicht 403 angeordnet. Die Schicht 403 kann eine Oberfläche der elektrischen Isolierung bilden. Sie kann aber auch eine separate Schicht bestehend aus Ag, Ni, Cu, Al, Au, deren Legierungsbestandteilen oder dergleichen Materialien sein. Die Schicht 403 ist optional. Im Unterschied zu dem in Fig. 2 gezeigten Aufbau wird erfindungsgemäß kein zusätzliches Fügematerial eingesetzt.

Im Folgenden werden unter Bezug auf die Figuren 3 und 4 unterschiedliche Ausführungsbeispiele der vorliegenden Erfindung beschrieben.

Auf einem metallischen Grundwerkstoff 102 befindet sich als metallische Isolierung eine keramische Deckschicht 104. Die keramischen Deckschichten 104 sind im Allegemeinen mit einer Haftvermittlungsschicht 403 beschichtet. Diese Haftvermittlungsschicht 403 wird nur dort aufgebracht, wo auch Leiterbahnen 106 sich befinden. Als Beispiel einer Haftvermittlungsschicht 403 sei eine üblich NiAu-Beschichtung genannt. Im Falle der Verwendung von Ag-Basis Leiterbahnen 106 kann dies auch eine NiAg- Ag- oder Au-Schicht 403 sein. Wenn die keramische Deckschicht 104 über thermisches Spritzen auf einen Grundwerkstoff aufgebracht wird, ist es eventuell möglich, auf eine Haftvermittlungsschicht 403 auf der Keramik 104 zu verzichten, da die thermische Spritzschicht eine hohe Rauigkeit aufweist und sich beim Fügen das Leiterbahnmaterial 106 mechanisch in die keramische Beschichtung 104 verkrallt. Für die Haftvermittlungsschicht 209 auf den thermoelektrischen Materialien 110 gilt das Analoge, d.h. die thermoelektrischen Werkstoffe 110 werden im Allgemeinen mit einer Haftvermittlungsschicht 209 belegt, wie z.B. NiAu, NiAg, Ag, Au, Al, Cu, Ni oder dergleichen. Wenn die Oberfläche des thermoelektrischen Materials 110 eine gewisse Rauigkeit aufweist, wie dies beispielsweise bei gesintertem Material oder mit thermoelektrischem Material infiltrierten Trägerstrukturen der Fall sein kann, kann gegebenenfalls auf Haftvermittlungsschichten 209 verzichtet werden. Dies ist im Einzelfall zu prüfen. Dadurch, dass kein separates Fügematerial mehr verwendet wird, ist die Anzahl der verschiedenen Werkstoffe im thermoelektrischen Modul reduziert und damit auch die Anzahl von Auslösern von thermoelektrischen Spannungen.

Bevorzugt ist es grundsätzlich, wenn die verwendeten Materialien möglich gleiche oder ähnliche thermische Ausdehnungskoeffizienten aufweisen, um die thermischen Spannungen weiter zu verringern. Wenn die thermischen Ausdehnungskoeffizienten der Materialein von der kalten zur heißen Seite hin geeignet abnehmen, kann die höhere Wärmeausdehnung der Werkstoff auf Grund der höheren Temperatur auf der heißen Seite kompensiert werden.

Als Leiterbahnmaterial 106 werden massiv metallische Gläser (MMG) vorgeschlagen. Massiv metallische Gläser gehören zu den aktuell modernsten Materialklassen. Sie sind im festen Zustand nicht metallisch kristallin, sondern amorph. Durch geschickte Legierung reichen bereits Abkühlraten von wenigen Kelvin pro Sekunde aus, um deren Kristallisation zu unterdrücken. Als Materialbeispiel sei eine beispielhafte Legierung bestehend aus 41,2 % Zr, 13,8 % Ti, 12,5 % Cu, 10 % Ni, und 22,5 % Be genannt. Daneben gibt es aber auch Legierungen auf Basis von Pd, Mg, Pt, W, NbNi, Fe, Tu, Cu, etc.. Massiv metallische Gläser weisen elastische Dehnungen von ca. 2 % auf. Edelstahl weist im Vergleich dazu ca. 0,2 % auf. Deshalb können thermomechanische Spannungen, die sich durch unterschiedliche thermische Ausdehnung der beiden verbundenen Materialien, wie z.B. Metall und Keramik, im Betrieb ergeben, in der Leiterbahn-Fügenaht aufgenommen werden.

Zum Fügen werden auf die Grundplatte, bestehend aus metallischem Grundmaterial 102 und keramischer Deckschicht 104, in einer geeigneten Vorrichtung, beispielsweise einer Kassettiervorrichtung die MMG-Leiterbahnen 106 aus massiv metallischem Glas gelegt und die thermoelektrischen Materialien 110 darüber platziert. Durch Erwärmen des Ensembles unter Anwendung von Druck erfolgt die Fügung der Leiterbahn 106 an die keramische Deckschicht 104 und des thermoelektrischen Materials 110 an die Leiterbahn 106. Zusätzlich können die Leiterbahnen 116 der zweiten Grundplatte 112, 114 und die zweite Grundplatte 112, 114 selbst mit eingelegt und das kann Modul in einem Schritt gefügt werden.

Beim Fügen hängt die Maximaltemperatur des Fügeprozesses von der gewählten Legierung des massiv metallischen Glases ab und von der geometrischen Struktur der Fügepartner ab. Als Orientierung dient die Glasübergangstemperatur des massiv metallischen Glases. Für eine Legierung auf Zr-Basis beträgt diese 300-400 °C, für eine Legierung auf NbNi-Basis ca. 600 °C. Da es sich bei der Fügung um einen Verpressvorgang und nicht um eine Lötung mit entsprechender chemischer Bindung zwischen Fügepartner und Fügematerial handelt, ist es hilfreich, wenn die Fügepartner eine Rauigkeit aufweisen. Besonders bevorzugt ist es, wenn die Fügepartner eine Porosität aufweisen wie dies bei thermischen gespritzten Materialien und/oder bei Materialien, die mittels Pulvermetallurgie erzeugt wurden, der Fall ist. Die Verpresstemperatur muss so gewählt werden, dass das massiv metallische Leiterbahn-Fügematerial in die Spalte und Poren des Fügepartners eindringen kann und somit eine mechanische Verkrallung stattfindet. Die Dicke des massiv metallischen Glas-Fügematerials beträgt zwischen 2,0 und 0,2 mm. Die lateralen Abmessungen der MMG-Leiterbahnen 106 orientieren sich an den üblichen Abmaßen von einem bis wenigen Millimetern in Länge und Breite. Um die Verkrallung zu erreichen, ist ggf. eine Erwärmung auf eine Temperatur oberhalb der Glasübergangstemperatur nötig. Um die amorphe Metallstruktur zu erhalten, muss die Zeit oberhalb der Glasübergangstemperatur auf einige Minuten reduziert werden und genügend schnell abgekühlt werden. Um letzteres zu realisieren, kann beispielsweise durch Aufpressen eines geheizten Kolbens Wärme zugeführt werden und anschließend ein gekühlter Kolben aufgepresst werden, um die gewünschte Abkühlgeschwindigkeit zu erreichen. Eine andere Möglichkeit ist es, induktiv zu erwärmen und anschließend über Anblasen mit einem Kaltgasstrom zu kühlen.

Ein alternatives Applizierungsverfahren der Leiterbahnen 106 aus massiv metallischen Gläsern ist das thermische Spritzen unter Verwendung entsprechender Masken. Vorteile sind, dass die genügend schnelle Abkühlung der gespritzten Leiterbahnen 106 und die Verkrallung in das keramische Deckschichtmaterial 104 sicher gewährleistet sind. Allerdings muss der thermoelektrische Werkstoff 110 in einem zusätzlichen Schritt aufgefügt werden.

Mit Blick darauf, welches massiv metallisches Glas als Leiterbahn 106 verwendet wird, ist es von Vorteil, dass das Leiterbahnmaterial einen ähnlichen thermischen Ausdehnungskoeffizienten wie das metallische Grundmaterial 102 und die keramische Isolierschicht 104 besitzt. Bei Verwendung von ferritischem Edelstahl als Grundmaterial 102 und Al₂O₃ oder bevorzugt Al₂O₃-/ZrO₂-Mischoxid als Isoliermaterial 104 ist ein Fe-Basis massiv metallisches Glas, wie amorpher Stahl oder Edelstahl, oder die vorbezeichnete beispielhafte Legierung mit einem thermischen Ausdehnungskoeffizienten von 10·10⁻⁶ 1/K zusätzlich von Vorteil. Bei letzterer ist die Glas-Übergangstemperatur von 300 bis 400 °C zu beachten, die im Betrieb nicht dauerhaft überschritten werden darf. Als thermoelektrisches Material 110 kann vorteilhaft CoSb₃ gewählt werden auf Grund des relativ niedrigen Ausdehnungskoeffizienten von ca. 12 ppm/K.

Als alternatives, nicht erfindungsgemäßes, Leiterbahnmaterial werden gesinterte Werkstoffe bevorzugt auf Ag-Basis vorgeschlagen. Dabei können Metallpasten verwendet werden, die eine Silberverbindung enthalten und die bei Temperaturen unter 300 °C bzw. unter 200 °C zu einer stabilen porösen Ag-Schicht sintern. Insbesondere durch Hinzufügen von Sinteradditiven, die zu einer Reduktion der Oxide auf der Oberfläche der Ag-Partikel führen, gelingt es die Verarbeitungstemperatur auf die vorbezeichneten niedrigen Werte zu drücken. Die Verwendung von Nanosilber ist nicht erforderlich.

Der grundsätzliche Fügevorgang erfolgt im Wesentlichen analog zu dem Verfahren bei Verwendung von massiv metallischen Gläsern als Leiterbahnen 106. Die Ag-Sinterpaste wird durch Siebdruck, Schablonendruck, Dispensertechnik oder ähnliches auf die Grundplatte, bestehend aus dem metallischen Grundwerkstoff 102 und der keramischen Deckschicht 104 auf die gewünschten Stellen appliziert. Dann werden unter Verwendung einer Kassettiervorrichtung die thermoelektrischen Materialien 110 auf die Schicht aus Ag-Paste aufgelegt und gegebenenfalls angedrückt. Anschließend wird das Ensemble unter Anwendung von Temperaturen von ≤ 300 °C, entweder drucklos oder unter Anwendung eines Drucks von einigen MPa, gefügt. In einer Variante wird vor dem Fügen bereits die zweite mit Ag-Paste geeignet lokal belegte Grundplatte 112, 114 auf das Ensemble aufgelegt und das gesamte Modul in einem Schritt gefügt. Die Schichtdicke der Leiterbahn 106 aus Ag-Paste beträgt vor der Fügung typischerweise 50 µm. Aber auch andere Schichtdicken insbesondere dickere Schichten sind geeignet.

Die Ag-Leiterbahn 106 weist nach dem Fügen eine Restporosität auf, die von den Fügeparametern, insbesondere dem Druck abhängt. Diese Restporosität mindert zwar die elektrische Leitfähigkeit der Leiterbahnen 106, erhöht aber deren thermomechanische Beständigkeit. Mit Blick auf den relativ hohen thermischen Ausdehnungskoeffizienten von ca. 19 ppm/K von Silber ist dies erwünscht. Dem Fachmann ist bekannt, dass der thermische Ausdehnungskoeffizient von metallischen Elementen wie Ag durch Zumischung von anderen Elementen mit niedrigerem thermischem Ausdehnungskoeffizienten, wie z. B. Fe, Ta, W, Cr abgesenkt werden kann. Solches legiertes Material auf Ag-Basis kann für die Leiterbahnen 106 bevorzugt verwendet werden.

Das Silber der gesinterten Ag-Schicht hat dieselbe Schmelztemperatur wie massives Silber, nämlich 962 °C, d.h. auch bei hoher Betriebstemperatur des thermoelektrischen Moduls von 600 °C wird die Fügenaht nicht aufschmelzen.

Natürlich kann ein Modul auch dergestalt aufgebaut werden, dass die Leiterbahn 106 auf der einen Seite aus einem massiv metallischen Glas besteht und auf der anderen Seite aus einer Ag- oder Ag-Basis Sinterschicht.

Fig. 5 zeigt ein Ablaufdiagramm zur Herstellung eines thermoelektrischen Moduls gemäß einem Ausführungsbeispiel der vorliegenden Erfindung. Bei dem thermoelektrischen Modul kann es sich um das in Fig. 3 gezeigte thermoelektrische Modul handeln. In einem Schritt 501 wird eine elektrische Isolierung bereitgestellt, auf die in einem Schritt 503 eine elektrische Leiterbahn gefügt wird. In einem Schritt 505 wird auf die elektrische Leiterbahn ein thermoelektrisches Material gefügt. In einem Schritt 507 wird auf das thermoelektrische Material eine weitere elektrische Leiterbahn gefügt. In einem Schritt 509 wird auf die weitere elektrische Leiterbahn eine weitere elektrische Isolierung gefügt. Die Schritte 503, 505, 507, 509 können gleichzeitig durchgeführt werden. In weiteren Schritten können die elektrische Leiterbahn, das thermoelektrische Material, die weitere elektrische Leiterbahn und die weitere elektrische Isolierung bereitgestellt werden. Ferner können zu geeigneten Zeitpunkten beidseitig metallische Grundwerkstoffe bereitgestellt und mit den elektrischen Isolierungen verbunden werden.

Die beschriebenen Ausführungsbeispiele sind nur beispielhaft gewählt und können miteinander kombiniert werden.

## Patentansprüche

1. Thermoelektrisches Modul, mit folgenden Merkmalen:
einer elektrischen Isolierung (104);
einer elektrischen Leiterbahn (106), wobei eine Oberfläche der elektrischen Leiterbahn an eine Oberfläche der elektrischen Isolierung angefügt ist; und
einem thermoelektrischen Material (110), wobei eine Oberfläche des thermoelektrischen Materials an eine weitere Oberfläche der elektrischen Leiterbahn angefügt ist,
mit einer weiteren elektrischen Leiterbahn (116), die auf einer der elektrischen Leiterbahn gegenüberliegenden Seite des thermoelektrischen Materials (110) angeordnet ist und mit einer weiteren elektrischen Isolierung (114), die auf einer dem thermoelektrischen Material gegenüberliegenden Seite der weiteren elektrischen Leiterbahn angeordnet ist,
wobei die elektrische Leiterbahn (106) aus einem metallischen Glas besteht,
wobei der thermische Ausdehnungskoeffizient der elektrischen Isolierung (104) kleiner als der thermische Ausdehnungskoeffizient der elektrischen Leiterbahn (106) und der thermische Ausdehnungskoeffizient der elektrischen Leiterbahn kleiner als der thermische Ausdehnungskoeffizient des thermoelektrischen Materials (110) ist.

2. Thermoelektrisches Modul gemäß Anspruch 1, mit Haft- und Barriereschichten bestehend aus Ag, Ni, Cu, Al, Au oder deren Legierungen

3. Verfahren zur Herstellung eines thermoelektrischen Moduls, das die folgenden Schritte umfasst:
Bereitstellen (501) einer elektrischen Isolierung (104);
Anfügen (503) einer Oberfläche einer elektrischen Leiterbahn (106) an eine Oberfläche der elektrischen Isolierung; und
Anfügen (505) einer Oberfläche eines thermoelektrischen Materials (110) an eine weitere Oberfläche der elektrischen Leiterbahn,
wobei die Schritte des Anfügens als ein Verpressvorgang zeitgleich durchgeführt werden, mit einem Schritt des Legens der aus metallischem Glas bestehenden elektrischen Leiterbahn (106) auf die elektrische Isolierung (104) oder mit einem Schritt des Spritzens eines die aus metallischem Glas bestehende elektrischen Leiterbahn (106) ausbildenden Leiterbahnmaterials auf die elektrische Isolierung (104).

4. Verfahren gemäß Anspruch 3, mit einem Schritt des Sinterns der aus einem gesinterten Werkstoff bestehenden elektrischen Leiterbahn (106) auf die elektrische Isolierung (104).

5. Verfahren gemäß einem der Ansprüche 3 oder 4, mit einem Schritt (507) des Anfügens einer Oberfläche einer weiteren elektrischen Leiterbahn (116) an eine der elektrischen Leiterbahn gegenüberliegenden Oberfläche des thermoelektrischen Materials (110) und einem Schritt (509) des Anfügens einer Oberfläche einer weiteren elektrischen Isolierung (114) an eine dem thermoelektrischen Material gegenüberliegenden Oberfläche der weiteren elektrischen Leiterbahn.

## Claims

1. A thermoelectric module, having the following features:
an electric insulation (104);
an electric conductor track (106), wherein a surface of the electric conductor track is joined to a surface of the electric insulation; and
a thermoelectric material (110), wherein a surface of the thermoelectric material is joined to a further surface of the electric conductor track,
having a further electric conductor track (116) which is arranged on a side of the thermoelectric material (110) lying opposite the electric conductor track, and having further electric insulation (114) which is arranged on a side of the further electric conductor track lying opposite the thermoelectric material,
wherein the electric conductor track (106) is composed of a metallic glass,
wherein the coefficient of thermal expansion of the electric insulation (104) is lower than the coefficient of thermal expansion of the electric conductor track (106), and the coefficient of thermal expansion of the electric conductor track is lower than the coefficient of thermal expansion of the thermoelectric material (110).

2. The thermoelectric module as claimed in claim 1, having adhesive and barrier layers composed of Ag, Ni, Cu, Al, Au or their alloys.

3. A method for producing a thermoelectric module which comprises the following steps:
providing (501) an electric insulation (104);
joining (503) a surface of an electric conductor track (106) to a surface of the electric insulation; and
joining (505) a surface of a thermoelectric material (110) to a further surface of the electric conductor track,
wherein the joining steps are carried out simultaneously as a pressing process,
having a step of laying the electric conductor track (106) composed of metallic glass onto the electric insulation (104), or having a step of spraying a conductor track material, forming the electric conductor track (106) which is composed of metallic glass, onto the electric insulation (104).

4. The method as claimed in claim 3, having a step of sintering the electric conductor track (106) composed of a sintered material onto the electric insulation (104).

5. The method as claimed in one of claims 3 or 4, having a step (507) of joining a surface of a further electric conductor track (116) to a surface of the thermoelectric material (110) lying opposite the electric conductor track and a step (509) of joining a surface of a further electric insulation (114) to a surface of the further electric conductor track lying opposite the thermoelectric material.

## Revendications

1. Module thermoélectrique ayant les caractéristiques suivantes :
une isolation électrique (104) ;
une piste conductrice électrique (106) où une surface de la piste conductrice électrique est jointe à une surface de l'isolation électrique ; et
un matériau thermoélectrique (110) où une surface du matériau thermoélectrique est jointe à une autre surface de la piste conductrice électrique,
comprenant une autre piste conductrice électrique (116) qui est disposée sur un côté du matériau thermoélectrique (110), côté qui fait face à la piste conductrice électrique, et comprenant une autre isolation électrique (114) qui est disposée sur un côté de l'autre piste conductrice électrique, côté qui fait face au matériau thermoélectrique,
où la piste conductrice électrique (106) se compose d'un verre métallique,
où le coefficient de dilatation thermique de l'isolation électrique (104) est inférieur au coefficient de dilatation thermique de la piste conductrice électrique (106), et le coefficient de dilatation thermique de la piste conductrice électrique est inférieur au coefficient de dilatation thermique du matériau thermoélectrique (110).

2. Module thermoélectrique selon la revendication 1, comprenant des couches d'adhérence et des couches formant barrière, lesdites couches se composant d'éléments tels que Ag, Ni, Cu, Al, Au ou de leurs alliages.

3. Procédé de fabrication d'un module thermoélectrique, ledit procédé comprenant les étapes suivantes consistant :
à fournir (501) une isolation électrique (104) ;
à joindre (503) une surface d'une piste conductrice électrique (106), à une surface de l'isolation électrique ; et
à joindre (505) une surface d'un matériau thermoélectrique (110), à une autre surface de la piste conductrice électrique,
où les étapes de la jonction sont exécutées en même temps comme un processus de compression,
comprenant une étape de pose, sur l'isolation électrique (104), de la piste conductrice électrique (106) se composant de verre métallique, ou bien comprenant une étape d'injection, sur l'isolation électrique (104), d'un matériau de piste conductrice formant la piste conductrice électrique (106) se composant de verre métallique.

4. Procédé selon la revendication 3, comprenant une étape de frittage, sur l'isolation électrique (104), de la piste conductrice électrique (106) se composant d'un matériau fritté.

5. Procédé selon l'une des revendications 3 ou 4, comprenant une étape (507) de jonction d'une surface d'une autre piste conductrice électrique (116), à une surface du matériau thermoélectrique (110), surface qui fait face à la piste conductrice électrique, et comprenant une étape (509) de jonction d'une surface d'une autre isolation électrique (114), à une surface de l'autre piste conductrice électrique, surface qui fait face au matériau thermoélectrique.
